# EUROPEAN PATENT APPLICATION

(11) **EP 4 390 546 A1**
(43) Date of publication of application: **26.06.2024**
(21) Application number: 23200646.0
(22) Date of filing: 28.09.2023
(51) Int. Cl.: G03F 7/004, G03F 7/16

(54) **PRECURSORS AND METHODS FOR PRODUCING BISMUTH-OXY-CARBIDE-BASED PHOTORESIST**

(30) Priority: 22.12.2022 US 202218145038
(71) Applicant: INTEL Corporation, Santa Clara, CA 95054 (US)
(72) Inventor: MOKHTARZADEH, Charles Cameron, Portland, OR 97220 (US); BLACKWELL, James, Portland, OR 97201 (US); SEMPRONI, Scott, Fair Lawn, NJ 07410 (US); CLENDENNING, Scott B., Portland, OR 97225 (US); DOYLE, Lauren Elizabeth, Portland, OR 97239 (US)
(74) Representative: HGF

(57) **Abstract**

Precursors and methods related to a bismuth oxy-carbide-based photoresist are disclosed herein. In some embodiments, a method for forming a bismuth oxy-carbide-based photoresist may include exposing a bismuth-containing precursor and a co-reagent to a substrate to form a bismuth oxy-carbide-based photoresist having a formula BiₓO_{y}C_{z} on the substrate, where x is 1 or 2, y is between 2 and 4, and z is between 1 and 5, the bismuth-containing precursor having a formula R'Bi(NR₂)₂ or R'₂BiNR₂ where R includes methyl, ethyl, isopropyl, tert-butyl, or trimethylsilyl, or NR₂ is piperidine, and R' includes methyl, ethyl, isopropyl, tert-butyl, cyclo-pentyl, cyclo-hexyl, methyl trimethylsilyl, methyl 2-butyl, benzyl, 1-methyl 2-dimethyl propyl, or cyclopentadienyl. In some embodiments, the co-reagent includes water, hydrogen peroxide, oxygen, ozone, formic acid, maleic acid, or an alcohol.

## Description

### TECHNICAL FIELD

The present disclosure relates to manufacturing integrated circuits (ICs). More specifically, it relates to techniques, methods, and materials directed to metal oxide photoresist films for patterning.

### BACKGROUND

Electronic circuits when commonly fabricated on a wafer of semiconductor material, such as silicon, using lithography. Such electronic circuits are called ICs. ICs are typically fabricated by sequentially depositing and patterning layers of dielectric, conductive, and other semiconductor materials over a substrate to form an electrically connected network of electronic components and interconnect elements (e.g., capacitors, transistors, resistors, conductive traces, pads, and vias) integrated in a monolithic structure. A wafer with such ICs is typically cut into numerous individual dies. The dies may be packaged into an IC package containing one or more dies along with other electronic components. The IC package may be integrated onto an electronic system, such as a consumer electronic system.

### BRIEF DESCRIPTION OF THE DRAWINGS

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 illustrates example bismuth-containing precursors and substitution groups according to some embodiments of the present disclosure.
FIG. 2 illustrates an example reaction of a bismuth-containing precursor and a co-reagent to form a bismuth-oxy-carbide-based photoresist according to some embodiments of the present disclosure.
FIGS. 3A-3D illustrates example pathways for synthesizing an example bismuth-containing precursor according to some embodiments of the present disclosure.
FIGS. 4A-4D illustrates example pathways for synthesizing another example bismuth-containing precursor according to some embodiments of the present disclosure.
FIGS. 5A-5E illustrate cross-sectional views of an example fabrication process for forming, patterning, and developing a bismuth-oxy-carbide-based photoresist on a substrate according to some embodiments of the present disclosure.

### DETAILED DESCRIPTION

For purposes of illustrating IC packages manufactured using photolithography described herein, it is important to understand phenomena that may come into play during developing a metal oxide photoresist. The following foundational information may be viewed as a basis from which the present disclosure may be properly explained. Such information is offered for purposes of explanation only and, accordingly, should not be construed in any way to limit the broad scope of the present disclosure and its potential applications.

Photolithography is commonly used to pattern thin films during semiconductor processing, where photons are emitted from a light source onto a photosensitive photoresist to initiate a chemical reaction in the photoresist. When exposed to light, a photoresist may be further polymerized or cross linked to form a hardened coating which is resistant to etching solutions (e.g., negative-type photoresist) or may become more easily decomposable or dissolvable (e.g., positivetype photoresist). Thereafter, the photoresist is developed and exposed or unexposed portions of the photoresist are removed to form a pattern. A photoresist can be crucial to maintaining circuit element tolerances. A photoresist may be susceptible to degradation due to exposure from air or water, for example, during manufacturing processes delays. A degraded photoresist may become more easily removed, which may cause the photoresist to dissolve and/or lift away from the substrate and further expose the underlying metal resulting in decreased resolution and additional underlying metal to be etched away. A degraded photoresist may result in inaccurate patterning and other defects, which decreases manufacturing yields and increases costs. Ways to mitigate the degradation of a photoresist may be desired. Current photolithography processes use ultraviolet (UV) light with a wavelength between 10 nanometers and 400 nanometers or extreme ultraviolet radiation (EUV) with a wavelength between 10 nanometers and 15 nanometers (e.g., 13.5 nanometers +/- 2%), which may be used for providing improved pattern resolution in advanced integrated circuits where reduction in feature sizes is required. Metal oxide photoresists, specifically photoresists containing bismuth (Bi) metal (e.g., bismuth-oxy-carbide-based photoresists), may be especially suitable for EUV photopatterning. In particular, a bismuth-containing precursor/photoresist may increase an overall thermal stability and longevity of the precursor/photoresist as compared to traditional precursors/photoresists containing other metals. Additionally, bismuth has a high EUV absorption cross-section and may provide increased EUV reactivity in a bismuth-containing photoresist, which may result in reduced EUV dosing, increased resolution, and more contrast at a lower dosage.

Accordingly, Precursors and methods related to a bismuth-oxy-carbide-based photoresist are disclosed herein. In some embodiments, a method for forming a bismuth-oxy-carbide-based photoresist may include exposing a bismuth-containing precursor to a substrate, physisorbing or chemisorbing the bismuth-containing precursor on the substrate, and exposing the substrate with the physisorbed or chemisorbed bismuth-containing precursor to a co-reagent to form a bismuth-oxy-carbide-based photoresist having a formula BiₓO_{y}C_{z} on the substrate, where x is 1 or 2, y is between 2 and 4, and z is between 1 and 5, where the bismuth-containing precursor has a formula R'Bi(NR₂)₂ or R'₂BiNR₂, where R is methyl, ethyl, isopropyl, tert-butyl, or trimethylsilyl, or NR₂ is piperidine, and where R' is methyl, ethyl, isopropyl, tert-butyl, cyclo-pentyl, cyclo-hexyl, methyl trimethylsilyl, methyl 2-butyl, benzyl, 1-methyl 2-dimethyl propyl, or cyclopentadienyl. The co-reagent may include one or more of water, hydrogen peroxide, oxygen, ozone, formic acid, maleic acid, and an alcohol, where the alcohol has a formula R"-OH, and where R" is an alkyl group.

Each of the methods and materials of the present disclosure may have several innovative aspects, no single one of which is solely responsible for all the desirable attributes disclosed herein. Details of one or more implementations of the subject matter described in this specification are set forth in the description below and the accompanying drawings.

In the following detailed description, various aspects of the illustrative implementations may be described using terms commonly employed by those skilled in the art to convey the substance of their work to others skilled in the art.

The term "coupled" means either a direct connection (which may be one or more of a mechanical, electrical, and/or thermal connection) between the things that are connected, or an indirect connection through one or more intermediary objects between the things that are connected.

The description uses the phrases "in an embodiment" or "in embodiments," which may each refer to one or more of the same or different embodiments.

Furthermore, the terms "comprising," "including," "having," and the like, as used with respect to embodiments of the present disclosure, are synonymous.

The term "dispose" as used herein refers to position, location, placement, and/or arrangement rather than to any particular method of formation.

The term "between," when used with reference to measurement ranges, is inclusive of the ends of the measurement ranges.

The terms "substantially," "close," "approximately," "near," and "about," generally refer to being within +/- 20% of a target value (e.g., within +/- 5% or 10% of a target value) based on the context of a particular value as described herein or as known in the art.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). When used herein, the notation "A/B/C" means (A), (B), and/or (C).

Although certain elements may be referred to in the singular herein, such elements may include multiple sub-elements.

Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

In the following detailed description, reference is made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

The accompanying drawings are not necessarily drawn to scale.

In the drawings, same reference numerals refer to the same or analogous elements/materials shown so that, unless stated otherwise, explanations of an element/material with a given reference numeral provided in context of one of the drawings are applicable to other drawings where element/materials with the same reference numerals may be illustrated. Further, the singular and plural forms of the labels may be used with reference numerals to denote a single one and multiple ones respectively of the same or analogous type, species, or class of element.

In the drawings, a particular number and arrangement of components are presented for illustrative purposes and any desired number or arrangement of such components may be present in various embodiments.

For convenience, if a collection of reference numerals designated with different numerals are present (e.g., 101-1, 101-2), such a collection may be referred to herein without the numerals (e.g., as "101").

Various operations may be described as multiple discrete actions or operations in turn in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

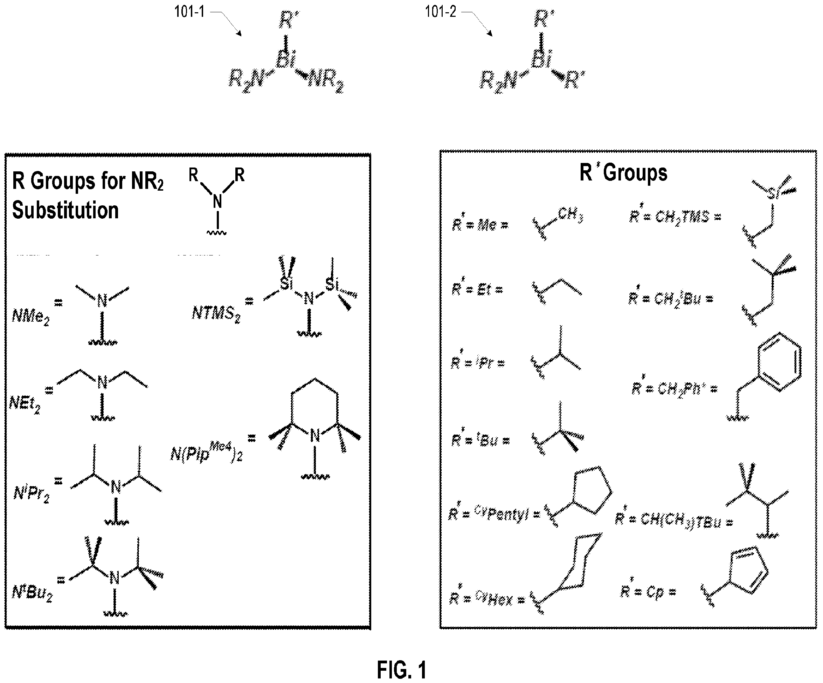

FIG. 1 illustrates example bismuth-containing precursors according to some embodiments of the present disclosure. A bismuth-containing precursor 101 may include a combination of bismuth-alkyl and bismuth-amide bonds. In some embodiments, a bismuth-containing precursor 101-1 may have a formula R'Bi(NR₂)₂. In some embodiments, a bismuth-containing precursor 101-2 may have a formula R'₂BiNR₂. The R group may be part of an amide ligand (e.g., NR₂ group), where the R group includes methyl, ethyl, isopropyl, tert-butyl, or trimethylsilyl, or the NR₂ group may include piperidine. The R' group may include methyl, ethyl, isopropyl, tert-butyl, cyclo-pentyl, cyclo-hexyl, methyl trimethylsilyl, methyl 2-butyl, benzyl, 1-methyl 2-dimethyl propyl, or cyclopentadienyl.

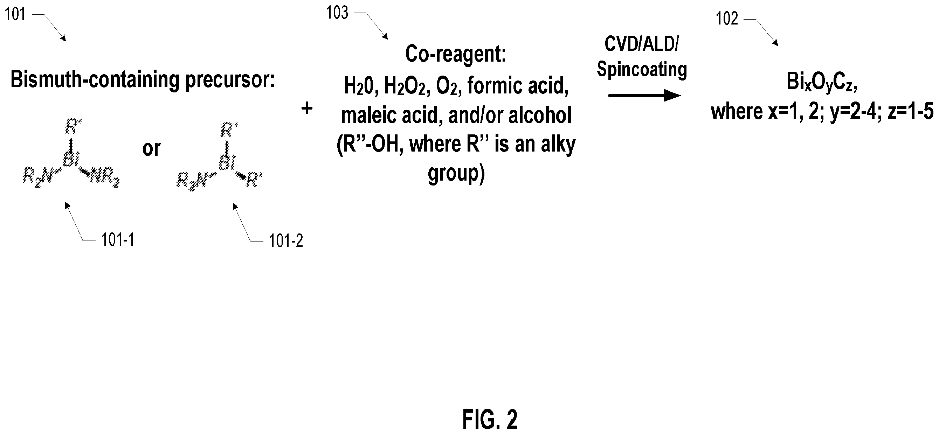

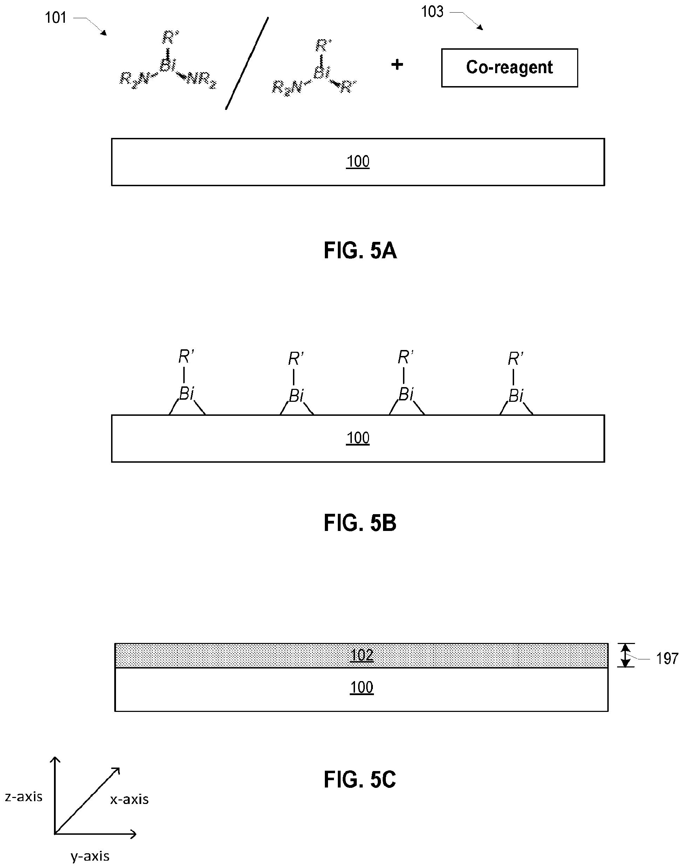

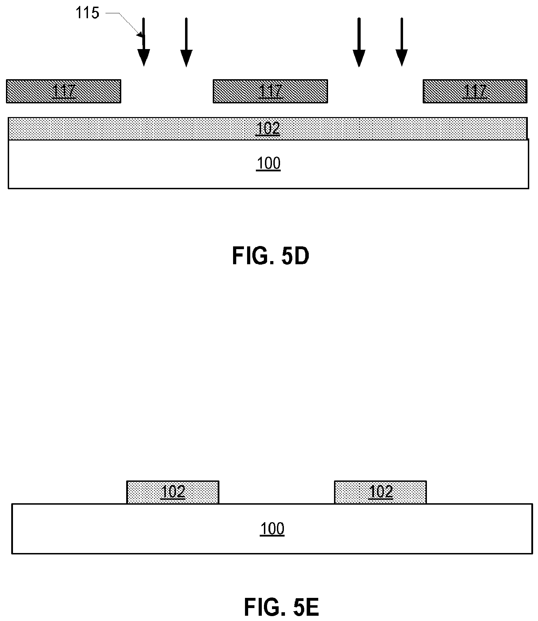

FIG. 2 illustrates an example reaction of a bismuth-containing precursor and a co-reagent to form a bismuth-oxy-carbide-based photoresist according to some embodiments of the present disclosure. A bismuth-containing precursor 101 (e.g., bismuth-containing precursor 101-1 may have a formula a formula R'Bi(NR₂)₂ or a bismuth-containing precursor 101-2 may have a formula R'₂BiNR₂) and a co-reagent 103 may be exposed to a substrate (e.g., a substrate 100 in FIG. 5)(not shown) and may react to form a bismuth-oxy-carbide-based photoresist 102 having a formula BiₓO_{y}C_{z} on the substrate, where x is 1 or 2, y is between 2 and 4, and z is between 1 and 5. A co-reagent 103 may include one or more of water, hydrogen peroxide, oxygen, ozone, formic acid, maleic acid, and an alcohol, where the alcohol has a formula R"-OH, and where R" is an alkyl group (e.g., methyl, ethyl, isopropyl, butyl, vinyl, or tert-butyl, among others). The bismuth-oxy-carbide-based photoresist 102 may be deposited on the substrate using any suitable process, such as chemical vapor deposition (CVD), atomic layer deposition (ALD), or spincoating. For example, the bismuth-oxy-carbide-based photoresist 102 may be formed by exposing the substrate to the bismuth-containing precursor 101 and the co-reagent 103 in a process chamber, which may be performed stepwise or simultaneously. In some embodiments, the deposition process may include two or more exposing steps. For example, an ALD process may be performed by first exposing the substrate to the vaporized bismuth-containing precursor 101 and, thereafter, exposing the substrate to the vaporized co-reagent 103 to form the bismuth-oxy-carbide-based photoresist 102. The exposing steps may be repeated one or more times to increase a thickness of the bismuth-oxy-carbide-based photoresist 102 on the substrate. In certain embodiments, the exposing steps may be separated temporally or spatially by changing the gas composition in a process chamber or by utilizing multiple spatially segregated sections within the process chamber and transporting the substrate from one section to another. The vapor deposition process may further include evacuating, purging, or both evacuating and purging, the process chamber between the exposing steps. In another example, a CVD process may be performed by exposing the bismuth-containing precursor 101 and the co-reagent 103 the process chamber simultaneously to grow the bismuth-oxy-carbide-based photoresist 102. In yet another example, a spincoating process may be used to deposit a solution of partially reacted bismuth-containing precursors 101 with one or more of the co-reagents 103 on a substrate. A spincoating process may help with control and uniformity of the deposition of bismuth-containing precursor 101 and co-reagent 103, which may result in a more uniform bismuth-oxy-carbide-based photoresist 102. The bismuth-oxy-carbide-based photoresist 102 may be deposited on a substrate at a fairly low temperature range, for example, at a temperature between 70 degrees Celsius and 250 degrees Celsius. In some embodiments, as described below with reference to FIG. 5B, a bismuth-containing precursor 101 be physisorbed or chemisorbed on a surface of a substrate during deposition, and the more stable bismuth-alkyl bonds may be retained in the bismuth-oxy-carbide-based photoresist 102 to be used as EUV-reactive handles for pattern formation. The bismuth-oxy-carbide-based photoresist 102, including the bismuth-containing precursors 101, may be detected, identified, and/or reverse engineered using any suitable technique, such as, for example, X-ray photoelectron spectroscopy (XPS), also known as electron spectroscopy for chemical analysis (ESCA), Fourier transform infrared (FTIR) spectroscopy, scanning electron microscopy (SEM) images, transmission electron microscope (TEM) images, ellipsometry, Time-of-Flight Secondary Ion Mass Spectrometry (TOF-SIMS), or non-contact profilometer, among others.

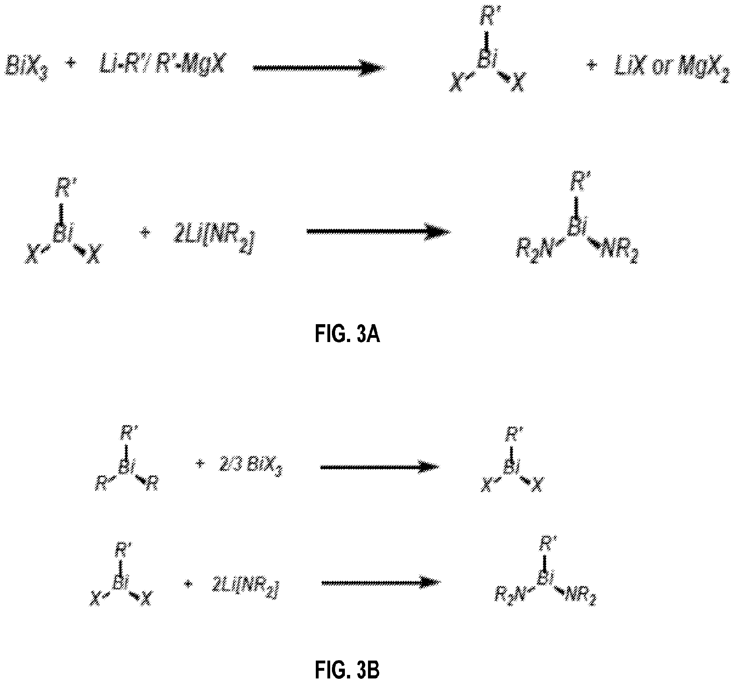

FIGS. 3A-3D illustrates example pathways for synthesizing an example bismuth-containing precursor 101-1 having a formula R'Bi(NR₂)₂ according to some embodiments of the present disclosure. FIG. 3A illustrates a reaction including bismuth trihalide or bismuth salt (BiX₃), wherein X is a halogen, such as fluorine (F), bromine (Br), chlorine (CI), iodine (I)) or trifluoromethanesulfonate (commonly referred to herein as triflate, OTf or SO₂CF₃,), and a lithium-based (LiR') reagent or a magnesium-halide-based (R'-MgX) reagent (e.g., a Grignard reagent), wherein R' is a group as described above with reference to FIG. 1, to form a bismuth dihalide with an R' group (BiR'X₂) and lithium or magnesium halides (LiX or MgX₂). The resulting bismuth dihalide with an R' group (BiR'X₂) may be reacted with a nitrogen-based lithium salt (Li(NR₂)), wherein the R is a group as described above with reference to FIG. 1, via a salt elimination reaction to form bismuth-containing precursor 101-1 having a formula R'Bi(NR₂)₂.

FIG. 3B illustrates a reaction including bismuth with one R' group and two R groups (BR'R₂) and 2/3 bismuth trihalide (BiX₃) to form a bismuth dihalide with an R' group (BiR'X₂). The resulting bismuth dihalide with an R' group (BiR'X₂) may be reacted with a nitrogen-based lithium salt (Li(NR₂)) via a salt elimination reaction to form bismuth-containing precursor 101-1 having a formula R'Bi(NR₂)₂.

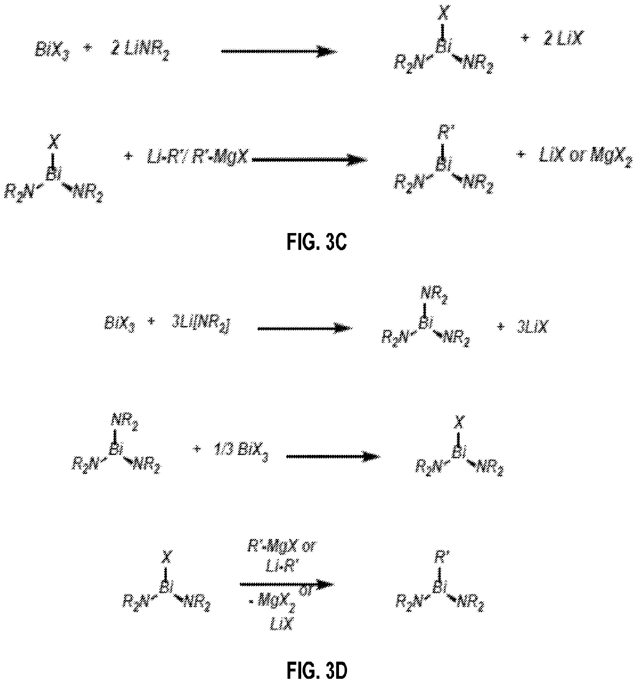

FIG. 3C illustrates a reaction including bismuth trihalide (BiX₃) and a nitrogen-based lithium salt (Li(NR₂)) to form a bismuth diamide halide with the amide having R groups (Bi(NR₂)₂X) and lithium halide (LiX). The resulting bismuth diamide halide (Bi(NR₂)₂X) may be reacted with a lithium-based (LiR') reagent or a magnesium-halide-based (R'-MgX) reagent to form bismuth-containing precursor 101-1 having a formula R'Bi(NR₂)₂ and lithium or magnesium halides (LiX or MgX₂).

FIG. 3D illustrates a reaction including bismuth trihalide (BiX₃) and a nitrogen-based lithium salt (Li(NR₂)) to form a bismuth triamide complex (Bi(NR₂)₃) and lithium halide (LiX). The resulting bismuth triamide complex (Bi(NR₂)₃) may be reacted with 1/3 bismuth trihalide (BiX₃) to form a bismuth diamide halide with the amide having R groups (Bi(NR₂)₂X). The resulting bismuth diamide halide (Bi(NR₂)₂X) may be reacted with a Grignard or lithium reagent (R'MgX, MgX₂, Li-R', LiX) to form bismuth-containing precursor 101-1 having a formula R'Bi(NR₂)₂.

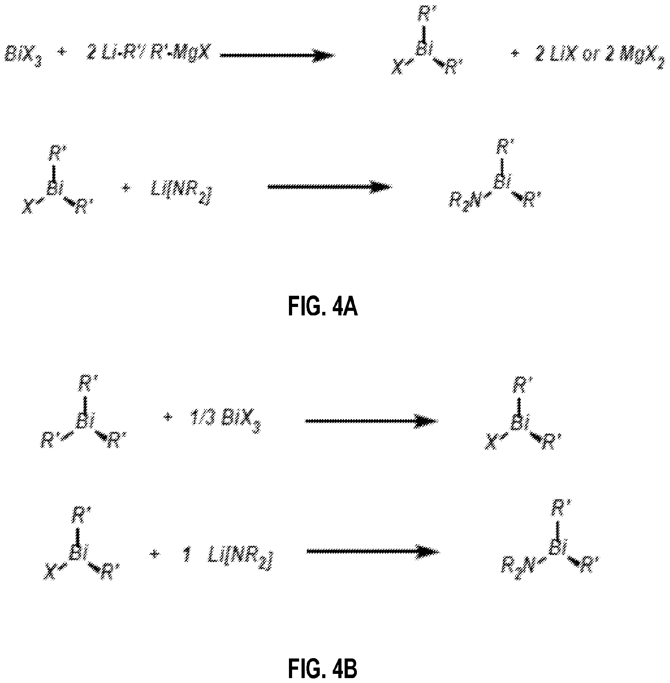

FIGS. 4A-4D illustrates example pathways for synthesizing an example bismuth-containing precursor 101-2 having a formula R'₂BiNR₂ according to some embodiments of the present disclosure. FIG. 4A illustrates a reaction including bismuth trihalide (BiX₃), where X is a halogen, and a lithium-based (LiR') reagent or a magnesium-halide-based (R'-MgX) reagent, where R' is a group as described above with reference to FIG. 1, to form a bismuth halide with two R' groups (BiR'₂X) and lithium or magnesium halides (LiX or MgX₂). The resulting bismuth halide with two R' groups (BiR'₂X) may be reacted with a nitrogen-based lithium salt (Li(NR₂)), where the R is a group as described above with reference to FIG. 1, via a salt elimination reaction to form bismuth-containing precursor 101-2 having a formula R'₂Bi(NR₂).

FIG. 4B illustrates a reaction including bismuth with three R' groups (BR'₃) and 1/3 bismuth trihalide (BiX₃) to form a bismuth halide with two R' groups (BiR'₂X). The resulting bismuth halide with two R' groups (BiR'₂X) may be reacted with a nitrogen-based lithium salt (Li(NR₂)) via a salt elimination reaction to form bismuth-containing precursor 101-2 having a formula R'₂BiNR₂.

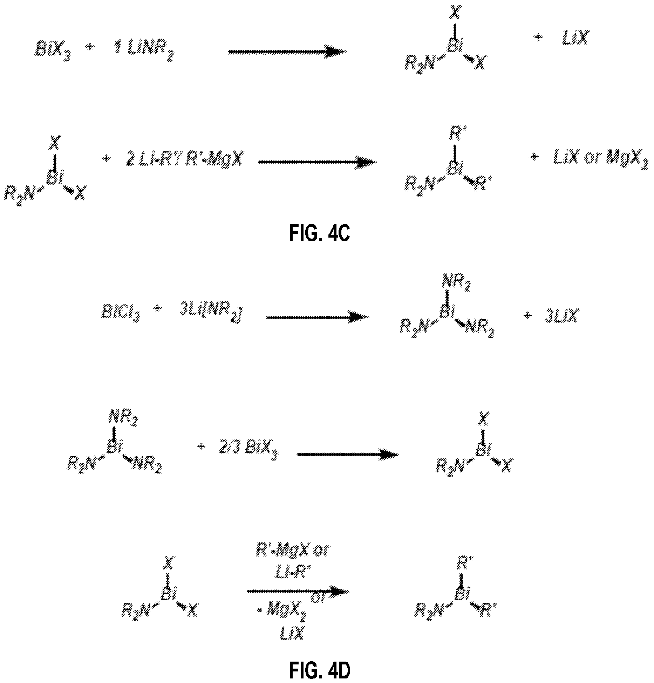

FIG. 4C illustrates a reaction including bismuth trihalide (BiX₃) and a nitrogen-based lithium salt (Li(NR₂)) to form a bismuth amide dihalide with the amide having R groups (BiNR₂X₂) and lithium halide (LiX). The resulting bismuth amide dihalide (BiNR₂X₂) may be reacted with a lithium-based (LiR') reagent or a magnesium-halide-based (R'-MgX) reagent to form bismuth-containing precursor 101-2 having a formula R'₂BiNR₂ and lithium or magnesium halides (LiX or MgX₂).

FIG. 4D illustrates a reaction including bismuth trichloride (BiCl₃) and a nitrogen-based lithium salt (Li(NR₂)) to form a bismuth triamide complex (Bi(NR₂)₃) and lithium halide (LiX). The resulting bismuth triamide complex (Bi(NR₂)₃) may be reacted with 2/3 bismuth trihalide (BiX₃) to form a bismuth amide dihalide with the amide having R groups (BiNR₂X₂). The resulting bismuth amide dihalide (BiNR₂X₂) may be reacted with a grinard or lithium reagent (R'MgX, Li-R', MgX₂, LiX) to form bismuth-containing precursor 101-2 having a formula R'₂BiNR₂.

FIGS. 5A-5E illustrate cross-sectional views of an example fabrication process for forming, patterning, and developing a bismuth-oxy-carbide-based photoresist on a substrate according to some embodiments of the present disclosure. FIG. 5A illustrates a bismuth-containing precursor 101 and a co-reagent 103 being exposed to a substrate 100. A substrate 100 may include a semiconductor material, such as silicon, and may include a wafer or a panel. In some embodiments, a substrate 100 may include multiple layers of dielectric material with conductive pathways therein. A bismuth-containing precursor 101 may include a bismuth-containing precursor 101-1 having a formula R'Bi(NR₂)₂ or may include a bismuth-containing precursor 101-2 having a formula R'₂BiNR₂. A co-reagent 103 one or more of water, hydrogen peroxide, oxygen, ozone, formic acid, maleic acid, and an alcohol, where the alcohol has a formula R"-OH, and where R" is an alkyl group. The bismuth-containing precursor 101 and the co-reagent 103 may be exposed to a substrate 100. The bismuth-containing precursor 101 and the co-reagent 103 may be exposed to the substrate 100 simultaneously or sequentially depending on the process utilized, as described above with reference to FIG. 1.

FIG. 5B illustrates an assembly subsequent to the bismuth-containing precursor 101 being chemisorbed on a surface of a substrate 100 during deposition illustrating that the R' group is bound to bismuth and is retained during the process.

FIG. 5C illustrates an assembly subsequent to forming a bismuth-oxy-carbide-based photoresist 102 on the substrate 100. The bismuth-oxy-carbide-based photoresist 102 may be formed using any suitable deposition process, such as, CVD, ALD, or spincoating, as described above with reference to FIG. 2. A bismuth-oxy-carbide-based photoresist 102 may have a thickness 197 (e.g., z-height) between 10 nanometers and 100 nanometers. In some embodiments, the assembly of FIG. 5C may be baked (e.g., exposed to heat at a temperature between 70 degrees Celsius and 250 degrees Celsius) in a process chamber to remove any excess solvents from a wet process and/or residual volatile byproducts from a dry process.

FIG. 5D illustrates an assembly subsequent to exposing the bismuth-oxy-carbide-based photoresist 102 to EUV 115 through a mask 117. The mask 117 may selectively expose areas of the photoresist to EUV 115 to create the pattern (e.g., exposed regions and unexposed regions), which may be used as a guide for deposition of copper and other materials on the substrate. In some embodiments, the assembly of FIG. 5D may be baked (e.g., exposed to heat at a temperature between 70 degrees Celsius and 250 degrees Celsius) in a process chamber to further polymerize or cross link the exposed regions (e.g., make the exposed regions less soluble) of the bismuth-oxy-carbide-based photoresist 102.

FIG. 5E illustrates an assembly subsequent to developing and removing the unexposed regions of the bismuth-oxy-carbide-based photoresist 102. The bismuth-oxy-carbide-based photoresist 102 may be developed by spraying or immersing the photoresist in a chemical solution (e.g., a developer solution), which dissolves the unexposed portions of the photoresist (e.g., in the case of a negative-type photoresist). When a negative-type photoresist is used, the mask 117 will have a negative image of the pattern to be produced, such that the pattern created is an opposite image of the mask 117 used. The unexposed regions of the bismuth-oxy-carbide-based photoresist 102 may be removed using any suitable process, such as a dry etch or a wet etch process. The assembly of FIG. 5E may undergo further manufacturing process to form one or more ICs.

The following paragraphs provide various examples of the embodiments disclosed herein.

Example 1 is a method for forming a photoresist, including exposing a precursor to a substrate, the precursor having a formula R'Bi(NR2)2, and may further specify that R is selected from the group consisting of methyl, ethyl, isopropyl, tert-butyl, and trimethylsilyl, or the NR2 group is piperidine, and R' is selected from the group consisting of methyl, ethyl, isopropyl, tert-butyl, cyclo-pentyl, cyclo-hexyl, methyl trimethylsilyl, methyl 2-butyl, benzyl, 1-methyl 2-dimethyl propyl, and cyclopentadienyl; exposing a co-reagent to the precursor and the substrate; and forming a photoresist on the substrate, the photoresist having a formula BixOyCz, wherein x is equal to 1 or 2, y is in the range of from 2 to 4, and z is in the range of from 1 to 5. The terms "between" and "in the range of" may be interchangeably used herein, and include the figures stated.

Example 2 may include the subject matter of Example 1, and may further specify that R is selected from the group consisting of methyl or ethyl, and R' is selected from the group consisting of ethyl, isopropyl, tert-butyl, cyclo-pentyl, cyclo-hexyl, and 1-methyl 2-dimethyl propyl.

Example 3 may include the subject matter of Examples 1 or 2, and may further specify that the co-reagent includes one or more of water, hydrogen peroxide, oxygen, ozone, formic acid, maleic acid, and an alcohol having a formula R"-OH, wherein R" is an alkyl group.

Example 4 may include the subject matter of Example 3, and may further specify that the co-reagent is alcohol having a formula R"-OH and R" is selected from the group consisting of methyl, ethyl, isopropyl, butyl, vinyl, and tert-butyl.

Example 5 may include the subject matter of any of Examples 1-4, and may further specify that forming the photoresist includes a chemical vapor deposition (CVD) process, an atomic layer deposition (ALD) process, or a spincoating process.

Example 6 may include the subject matter of any of Examples 1-5, and may further specify that a thickness of the photoresist is between 10 nanometers and 100 nanometers.

Example 7 may include the subject matter of any of Examples 1-6, and may further include selectively exposing the photoresist to extreme ultraviolet radiation (EUV) using a mask to create exposed and unexposed regions; developing the photoresist; and removing the unexposed regions of the photoresist.

Example 8 may include the subject matter of Example 7, and may further include baking the photoresist.

Example 9 is a method for forming a photoresist, including exposing a precursor to a substrate, the precursor having a formula R'2BiNR2, and may further specify that R is selected from the group consisting of methyl, ethyl, isopropyl, tert-butyl, and trimethylsilyl, or the NR2 group is piperidine, and R' is selected from the group consisting of methyl, ethyl, isopropyl, tert-butyl, cyclo-pentyl, cyclo-hexyl, methyl trimethylsilyl, methyl 2-butyl, benzyl, 1-methyl 2-dimethyl propyl, and cyclopentadienyl; exposing a co-reagent to the precursor and the substrate; and forming a photoresist on the substrate, the photoresist having a formula BixOyCz, wherein x is equal to 1 or 2, y is between 2 and 4, and z is between 1 and 5.

Example 10 may include the subject matter of Example 9, and may further specify that R is selected from the group consisting of methyl or ethyl, and R' is selected from the group consisting of ethyl, isopropyl, tert-butyl, cyclo-pentyl, cyclo-hexyl, and 1-methyl 2-dimethyl propyl.

Example 11 may include the subject matter of Examples 9 or 10, and may further specify that the co-reagent includes one or more of water, hydrogen peroxide, oxygen, ozone, formic acid, maleic acid, and an alcohol having a formula R"-OH, wherein R" is an alkyl group.

Example 12 may include the subject matter of Example 11, and may further specify that the co-reagent is alcohol having a formula R"-OH and R" is selected from the group consisting of methyl, ethyl, isopropyl, butyl, vinyl, and tert-butyl.

Example 13 may include the subject matter of any of Examples 9-12, and may further specify that forming the photoresist includes a chemical vapor deposition (CVD) process, an atomic layer deposition (ALD) process, or a spincoating process.

Example 14 may include the subject matter of any of Examples 9-13, and may further specify that a thickness of the photoresist is between 10 nanometers and 100 nanometers.

Example 15 may include the subject matter of any of Examples 9-14, and may further include selectively exposing the photoresist to extreme ultraviolet radiation (EUV) using a mask to create exposed and unexposed regions; developing the photoresist; and removing the unexposed regions of the photoresist.

Example 16 may include the subject matter of Example 15, and may further include baking the photoresist.

Example 17 is an apparatus, including a substrate; and a photoresist on the substrate, the photoresist having a formula BixOyCz, wherein x is equal to 1 or 2, y is between 2 and 4, and z is between 1 and 5.

Example 18 may include the subject matter of Example 17, and may further specify that a thickness of the photoresist is between 10 nanometers and 100 nanometers.

Example 19 may include the subject matter of Examples 17 or 18, and may further specify that the substrate includes a semiconductor material.

Example 20 may include the subject matter of any of Examples 17-19, and may further specify that the photoresist is a negative-type photoresist.

## Claims

1. A method for forming a photoresist, the method comprising:
exposing a precursor to a substrate, the precursor having a formula R'Bi(NR₂)₂ or R'₂BiNR₂, wherein R is selected from the group comprising methyl, ethyl, isopropyl, tert-butyl, and trimethylsilyl, or wherein the NR₂ group represents piperidine, and R' is selected from the group comprising methyl, ethyl, isopropyl, tert-butyl, cyclo-pentyl, cyclo-hexyl, methyl trimethylsilyl, methyl 2-butyl, benzyl, 1-methyl 2-dimethyl propyl, and cyclopentadienyl;
exposing a co-reagent to the precursor and the substrate; and
forming a photoresist on the substrate, the photoresist having a formula BiₓO_{y}C_{z}, wherein x is equal to 1 or 2, y is in the range of from 2 to 4, and z is in the range of from 1 to 5.

2. The method of claim 1, wherein R is selected from methyl or ethyl, and R' is selected from ethyl, isopropyl, tert-butyl, cyclo-pentyl, cyclo-hexyl, and 1-methyl 2-dimethyl propyl.

3. The method of claim 1 or 2, wherein the co-reagent includes one or more of water, hydrogen peroxide, oxygen, ozone, formic acid, maleic acid, and an alcohol having a formula R"-OH, wherein R" is an alkyl group.

4. The method of claim 3, wherein the co-reagent is an alcohol having a formula R"-OH and R" is selected from methyl, ethyl, isopropyl, butyl, vinyl, and tert-butyl.

5. The method of any one of claims 1-4, wherein forming the photoresist includes a chemical vapor deposition (CVD) process, an atomic layer deposition (ALD) process, or a spincoating process.

6. The method of any one of claims 1-5, wherein a thickness of the photoresist is between 10 nanometers and 100 nanometers.

7. The method of any one of claims 1-6, further comprising:
selectively exposing the photoresist to extreme ultraviolet radiation (EUV) using a mask to create exposed and unexposed regions;
developing the photoresist; and
removing the unexposed regions of the photoresist.

8. The method of claim 7, further comprising:
baking the photoresist.

9. The method of claim 1, wherein the precursor has the formula R'₂BiNR₂.

10. The method of claim 1, wherein the precursor has the formula R'Bi(NR₂)₂.

11. The method of any one of claims 1-10, wherein the precursor is synthesized from a bismuth halide or bismuth salt having a formula BiX, wherein X is selected from fluorine, bromine, chlorine, iodine, and/or triflate.

12. An apparatus, comprising:
a substrate; and
a photoresist on the substrate, the photoresist having a formula BiₓO_{y}C_{z}, wherein x is equal to 1 or 2, y is in the range of from 2 to 4, and z is in the range of from 1 and 5.

13. The apparatus of claim 12, wherein a thickness of the photoresist is between 10 nanometers and 100 nanometers.

14. The apparatus of claim 12 or 13, wherein the substrate includes a semiconductor material.

15. The apparatus of any one of claims 12-14, wherein the photoresist is a negative-type photoresist.
